# EUROPEAN PATENT SPECIFICATION

(11) **EP 2 604 667 B1**
(45) Date of publication and mention of the grant of the patent: **19.04.2017**
(21) Application number: 12197378.8
(22) Date of filing: 15.12.2012
(51) Int. Cl.: C09K 3/10

(54) **Package structure of electronic modules with silicone sealing frame**
Package-Struktur von elektronischen Baugruppen mit Silikon Dichtrahmen
Structure d'emballage de modules électroniques avec cadre de scellement en silicone

(30) Priority: 16.12.2011 TW 100146902
(43) Date of publication of application: 19.06.2013
(73) Proprietor: Prologium Holding Inc., Grand Cayman, KY1-1104 (KY)
(72) Inventor: Yang, Szu-Nan, Taipei (TW)
(74) Representative: Chaillot, Geneviève

(56) References cited:
- EP-A1- 1 728 829
- EP-A1- 1 998 087
- JP-A- 2009 245 782
- US-A1- 2002 164 476

## Description

### BACKGROUND OF THE INVENTION

### Field of Invention

The present invention relates to a package structure, in particular to a package structure using a silicone layer as a sealing frame of the electronic module.

### Related Art

Electronic modules, such as liquid crystal display (LCD module, dye-sensitized solar cell (DSSC) module, organic light-emitting diode (OLED) module, plasma display module, or thin battery cells module, include a pair of parallel electrode plates. The main body is disposed therebetween and packaged by a sealing frame. Therefore, the atmosphere, dirt, moisture, and other contamination which could destroy the module or affect its operation are isolated.

Generally speaking, there are two main kinds of materials for the sealing frame. The first one is the material with high polarity, such as epoxy resin, acrylic resin, UV glue, or Polyurethane (PU). It can be mixed with a solvent for dilution and coated or printed on the substrate. Then a cross-linking reaction is performed for polymerization by heating or exposure to ultraviolet, visible or near infrared irradiation. The second kind is the material, such as Polypropylene (PP), Polyethylene (PE), or thermoplastic polymer. These materials exhibit good fluidity in high temperature which is suitable for coating. And the hot-pressing process is performed for adhesion and generating partial crystalline region to isolate atmosphere, dirt, moisture.

For the first kind material, the material with high polarity, such as epoxy resin, acrylic resin, UV glue, or Polyurethane (PU), has good adhesion with almost all materials of the substrate, such as polyimide (PI), polyethylene terephthalate (PET), polyethylene naphthalate (PEN), metal, glass, glass fiber, and liquid crystal polymer, ceramic. These first kind materials, the material with high polarity, have polar functional groups. The substance inside the electronic modules, such as organic solvent, or plasticizer, is easy to permeate into the sealing frame. The adhesion and the isolation ability between the sealing frame and the substrates will be lowered. Especially, for the dye-sensitized solar cell (DSSC) module and the colloidal or liquid energy storage battery, the condition is worse.

For the second kind material, this material is non-polar and is suitable to utilize in the dye-sensitized solar cell (DSSC) module and the colloidal or liquid energy storage battery. However, the poor fluidity would bring about a great deal of trouble in pattern coating by printing. Also, the adhesion with the material of the substrate, such as metal or other materials with high polarity, is not good enough for sealing the pair of parallel electrode plates, such as LCD or OLED.

Accordingly, there is a need for new package structure/ material to overcome the above problems.

JP2009245782 relates to a dye-sensitized solar cell with 3-layer sealing member (a hydrophobic layer-a sealing member-a hydrophobic layer) between upper and lower electrodes to enhance sealing stability and reliability in long use. However, it discloses mainly the 3-layer sealing member containing silicone series resin. The upper-layer and the lower-layer sealing members are preferred to choose the same material, for example, the upper-layer sealing member contains a silicone series resin and the lower sealing layer may contain a denaturation silicone series resin. Meanwhile, the middle-layer sealing member, for example, contains a silicone series resin and a polysiloxane compound. It is only suggested that the 3 layers of the sealing member should choose the same series material as mentioned above. However, it does not disclose the detail of the materials used for the different 3 layers.

EP 1998087A1 relates to a waterproof gasket for mobile phone. The -Si-O-Si- disclosed in EP 1998087A1 only serves as a reactive surface treating agent to lower the insertion resistance of the waterproof gasket.

US2002/164476A1 discloses a conductive sealing material with a crosslinkable silicone and metal and/or inorganic fillers, and the sealing material is used for shielding housings that have to be opened and closed again frequently. Although it discloses that a silicone having the condensational silicone material and the additional silicone to adjust harness and/or adhesion strength, it is failing to disclose the detail of the materials.

Similar to US2002/164476A1, EP1728829A1 discloses a silicone having the condensational silicone material and the additional silicone. However, EP1728829A1 is failing to disclose the detail of the materials.

### SUMMARY OF THE INVENTION

It is an objective of this invention to provide a package structure. The sealing frame is made of silicone to improve moisture barrier, drug and corrosion resistant. Also, the erosion of polar solvent and plasticizer is avoided due to the characteristic of the silicone.

Another objective of this invention is to provide a package structure. At least one auxiliary sealing frame is disposed on the outside of the sealing frame to minimize the possibility of the moisture permeation.

This invention discloses a package structure according to claim 1. The PCB structure includes an upper substrate, a lower substrate, and a sealing frame. The sealing frame is disposed between the upper substrate and the lower substrate to seal an inner circumference to form a space therein. And the sealing frame including a silicone layer to improve moisture barrier to solve the problems of the moisture permeation. Also, the erosion of polar solvent and plasticizer is avoided due to the characteristic of the silicone to maintain the adhesion of the sealing frame and the upper/lower substrate.

Furthermore, to enhance the adhesion between the silicone and upper/lower substrate, the sealing frame has at least one modified silicone layer disposed between at least one of the substrates and the silicone layer. The at least one modified silicone layer has the interfacial tension and the polarity thereof to enhance the adhesion for different materials.

Further scope of applicability of the present invention will become apparent from the detailed description given hereinafter.

### BRIEF DESCRIPTION OF THE DRAWINGS

The present invention will become more fully understood from the detailed description given hereinbelow illustration only, and thus are not limitative of the present invention, and wherein:
FIGS. 1A and 1B illustrate the package structure of this present invention.
FIG. 2 illustrates the example of the conventional coating silicone layer.
FIG. 3 illustrates the package structure with modified silicone layers according to the present invention.
FIGS. 4A and 4B illustrate embodiments of package structure of the present invention, which show only one modified silicone layer is disposed.
FIG. 5 illustrates another embodiment of the package structure according to the present invention.
FIG. 6 illustrates another embodiment of the auxiliary sealing frame of the package structure according to the present invention.

### DETAILED DESCRIPTION OF THE INVENTION

The viscosity of the silicone can be adjusted by adding the silicone oil to be coated or printed on the substrate. Also the silicone can perform polymerization at lower temperature to reduce the thermal affection to the substance inside the electronic modules. Moreover, the silicone is a non-polar material. The organic solvent or plasticizer would not corrode or affect it. So, the moisture is not easy to be absorbed, humidified, and diffused into the sealing frame. Therefore, it is suitable to be as a package material.

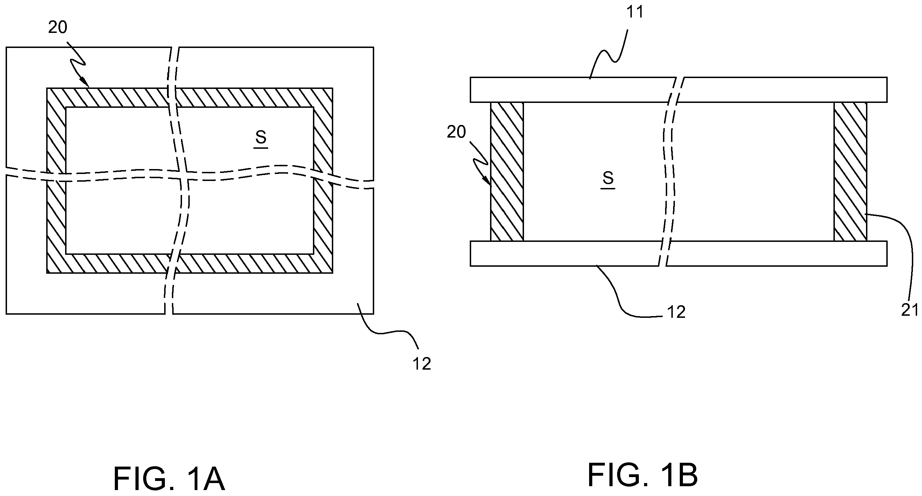

Please see FIGS. 1A and 1B, the package structure includes an upper substrate 11, a lower substrate 12 and a sealing frame 20. The upper substrate 11 and the lower substrate 12 may be the electrode plates of the electronic modules, such as liquid crystal display (LCD module, dye-sensitized solar cell (DSSC) module, organic light-emitting diode (OLED) module, plasma display module, or thin battery cells module. Therefore, the materials of the upper substrate 11 and the lower substrate 12 include polyimide (PI), polyethylene terephthalate (PET), polyethylene naphthalate (PEN), metal, glass, glass fiber, and liquid crystal polymer. The sealing frame 20 is disposed between the upper substrate 11 and the lower substrate 12 to seal an inner circumference to form a space S therein. The sealing frame 20 including a silicone layer 21 to improve moisture barrier to solve the problems of the moisture permeation into the electronic modules. Also, the erosion of polar solvent and plasticizer is avoid due to the characteristic of the silicone to maintain the adhesion of the sealing frame 20 and the upper substrate 11 or/and the lower substrate 12.

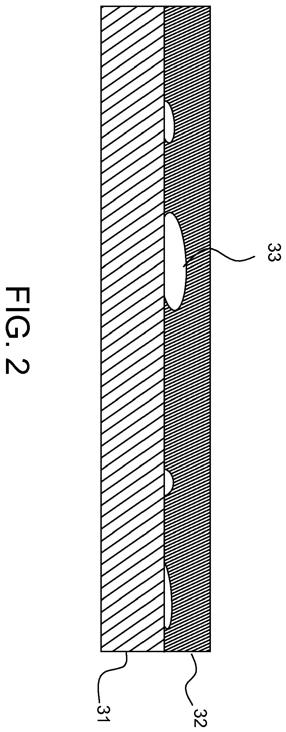

However, the silicone has a relatively weak adhesion. Like PP or PE, pure silicone does not have enough strong dispersive adhesion with most of materials of the substrate 11, 12. The silicone will perform both the condensation reaction and the addition reaction during curing. The structure cured by a condensation reaction has less adhesion force than an addition reaction. Also the byproduct of the condensation reaction is hydrogen, which is easy to produce bubbles. As refer to FIG. 2, the silicone layer 32 is disposed on the substrate 31 with different material. During polymerization, the gas, i.e. hydrogen, is moved randomly. When blocking by the substrate 31, due to the substrate 31 is made of compact material, such as metal, glass, or polymer, the gas is heaped up to form bubbles 33 at the interface therebetween. Due to the polarity of the silicone is very low, it would has repel force to moisture/water. In such package structure, the moisture only can permeate into the structure by slow diffusion along the interface, between the sealing frame 20 and the upper substrate 11 or the lower substrate 12. However, when there have bubbles 33 at the interface, the structure is easy to peel off. Also, the diffusion path for the moisture is much shortened. Then the permeation speed is increased to affect the moisture barrier of the package structure.

General speaking, the silicone is utilized in fill. In other words, one side of the silicone layer 32 is free, as shown in FIG. 2. If the polymerization is performed slowly, the produced gas can be exhausted slowly. However, in this invention, the silicone layer 21 is placed between the upper substrate 11 and the lower substrate 12, as shown in FIG. 1B. It has to perform hot pressing or thermal polymerization for curing. That will produce more gases. When the gas is moved randomly and blocked by the upper substrate 11 and the lower substrate layer 12. The heaped gas bubbles would crack the adhesion interface therebetween. Also, the gas bubbles will be merged to a larger one to make the adhesion be weaker. To form a structure with better moisture barrier, it has to accelerate the speed of forming the adhesion mechanism. However, the gas will be produced accordingly. Furthermore, the condensation reaction and the addition reaction will be performed at the same time. It is almost impossible to perform only one of the condensation reaction and the addition reaction.

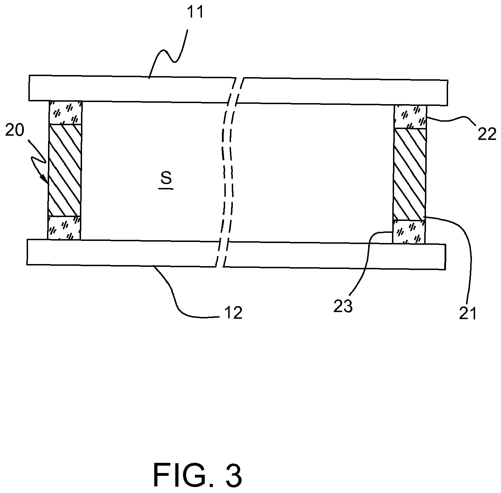

Please refer to FIG. 3, to solve this problem; the silicone layer 21 has two modified silicone layers 22, 23 disposed two sides thereon. The first modified silicone layer 22 is disposed between the silicone layer 21 and the upper substrate 11. The second modified silicone layer 23 is disposed between the silicone layer 21 and the lower substrate 12. The modified silicone layers 22, 23 have the interfacial tension and the polarity thereof modified depending on the materials of the upper substrate 11 and the lower substrate 12. Therefore, the good adhesion situations are presented on the interfaces between the first modified silicone layer 22 and the upper substrate 11, and the second modified silicone layer 23 and the lower substrate 12. Also, the amounts of the produced gas bubbles are decreased and the size of the gas bubbles is lessened. The modified silicone layers 22, 23 are modified by adjusting a proportion of condensation-type silicone and addition-type silicone and/or by adding Epoxy, Acrylic Acid or a combination thereof into silicone.

Take the following forming method for example, the modified silicone layers 22, 23 are formed on the upper substrate 11 and the lower substrate 12 respectively. Then the polymerization is performed slowly for curing. Due to one side is free, the produced gas can be exhausted. Also, the modified silicone layers 22, 23 are modified depending on the materials of the upper substrate 11 and the lower substrate 12. The good adhesion situations are presented on the interfaces between the first modified silicone layer 22 and the upper substrate 11, and the second modified silicone layer 23 and the lower substrate 12. Then the silicone layer 21 is disposed therebetween for curing to form the above-mentioned structure.

Due to the silicone layer 21 is disposed between the modified silicone layers 22, 23, which made of the same or substantially the same material, the adhesion force therebetween is high. Even the gas is produced, it is not easy to weaken the adhesion structure. Also, due to the silicone is not a compact material as the upper substrate 11 and the lower substrate 12. In micro-view, the silicone has larger hole inside. Even the silicone layer 21 is disposed between the modified silicone layers 22, 23 for curing, the produced gas is easily to be exhausted from the modified silicone layers 22, 23, and is not easy to heap up to form bubbles. The intermolecular forces between the silicone layer 21 and the modified silicone layers 22, 23 are equal. The gas flows inside are uniform. The gas bubbles will not easy to merge to a larger one. Therefore, the good adhesion situations are presented on the interfaces between the modified silicone layers 22, 23 and the silicone layer 21. The moisture is difficult to permeate by diffusion through the interfaces.

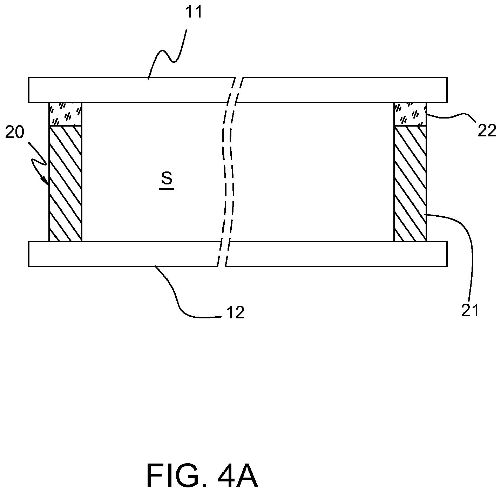

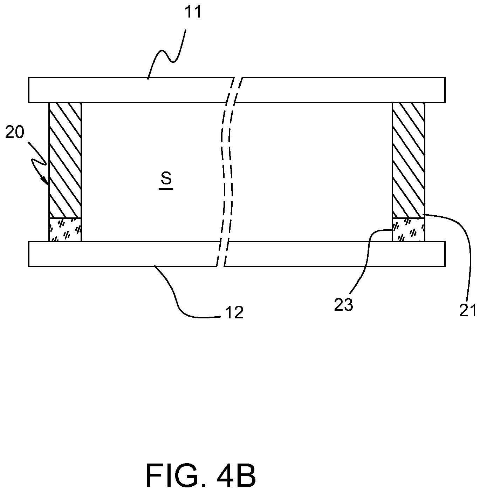

It is also disposed a modified silicone layer to one of the interfaces, which the adhesion situation is worse. For example, it only has the first modified silicone layer 22 to be disposed between the upper substrate 11 and the silicone layer 21, see FIG. 4A. Or, it only has the second modified silicone layer 23 to be disposed between the lower substrate 12 and the silicone layer 21, see FIG. 4B.

In micro-view, due to the modified silicone layers 22, 23 are induced chemical cross-linking structure during curing, the adhesion between the first modified silicone layer 22 and the upper substrate 11, and the second modified silicone layer 23 and the lower substrate 12, are very well. The moisture is difficult to permeate through these interfaces. However, the silicone layer 21 has to be cured by hot-pressing under the conditions that the modified silicone layers 22, 23 had already been cured. It is difficult to form chemical or physical cross-linking structure therebetween in a short time. Therefore, the interfaces between the silicone layer 21 and the modified silicone layers 22, 23 are the key-point that affect the moisture barrier.

The silicone layer 21 contains silicone represented by a chemical formula of:

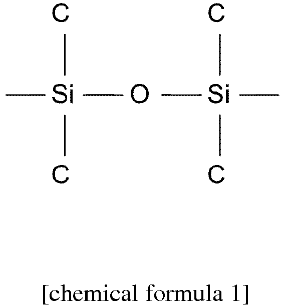

It is easy to induce crystalline structure to form better adhesive surface and three-dimensional barrier with the cross-linking structure of the modified silicone layers 22, 23. The silicone layer 21 can not only be composed silicone with the chemical formula 1, because of the condensation reaction and the addition reaction will be performed at the same time. The modified silicone layers 22, 23 also contain silicone represented by the chemical formula 1. To make it be easy to induce the crystalline structure, the amount of the silicone with the chemical formula 1 within the silicone layer 21 is great than the amount of the silicone with the chemical formula 1 within the modified silicone layers 22, 23 by 0.1 % to 60 %, on a weight/volume basis.

On the other hand, the silicone with the cross-linking structure, i.e. the modified silicone layers 22, 23, represented by a chemical formula of:

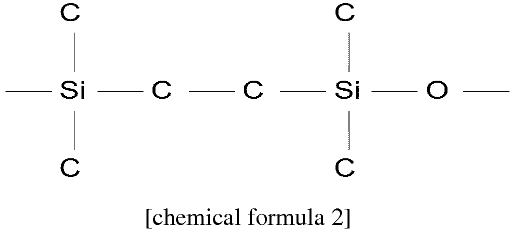

By comparing these two chemical formulas, it is obvious to recognize the differences between the amount of the carbon atoms and the oxygen atoms. Therefore, we can also define the amount of the carbon atoms of the modified silicone layers 22, 23 is great than the amount of the carbon atoms of the silicone layer 21 by about 0.01 to 60 mole percent. Or the amount of the oxygen atoms of the modified silicone layer 22, 23 is less than the amount of the oxygen atoms of the silicone layer 21 by about 0.01 to 60 mole percent.

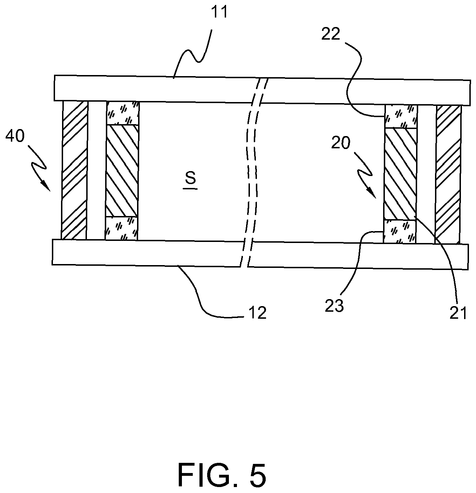

Moreover, if the silicone is not totally cured during polymerization, it is easy to perform reaction with the moisture and produce unwanted byproducts, such as water or hydrogen. To solve this problem, please refer to FIG. 5, an auxiliary sealing frame 40 is disposed between the upper substrate 11 and the lower substrate 12, and on the outside of the sealing frame 20. The auxiliary sealing frame 40 is made of material selected from the group consisting of epoxy, acrylic resin, UV glue, Polyethylene (PE),ethylene vinyl acetate (EVA), Polypropylene (PP), or a combination thereof, to isolate the outside moisture.

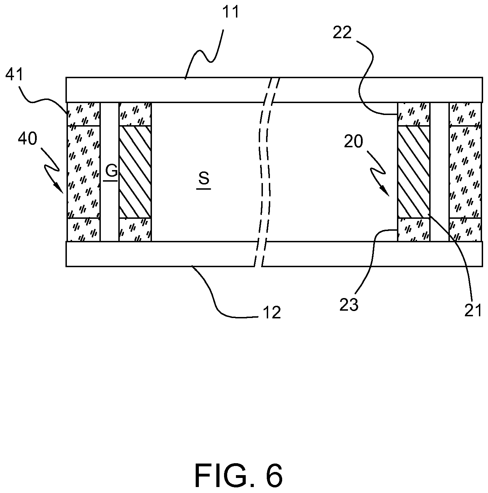

Furthermore, for the requirement of the moisture barrier is higher, the auxiliary sealing frame 40 includes three modified silicone layers 41, please see FIG. 6. As the above mentions, the moisture only can permeate into the structure by slow diffusion along the interfaces. When the vapor is saturated within the gap G between the auxiliary sealing frame 40 and the sealing frame 20, the moisture can start to permeate the inside space S. Therefore, the moisture barrier is very much improved.

## Claims

1. A package structure, comprising:
two substrates; and
a sealing frame, disposed between the two substrates to seal an inner circumference to form a space therein, the sealing frame including :
a silicone layer; and
at least one modified silicone layer disposed between at least one of the substrates and the silicone layer, wherein the silicone layer contains silicone represented by a chemical formula of: 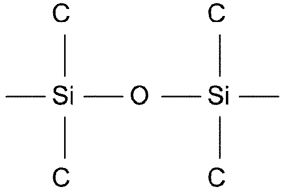
and the modified silicone layers contain silicone represented by a chemical formula of: 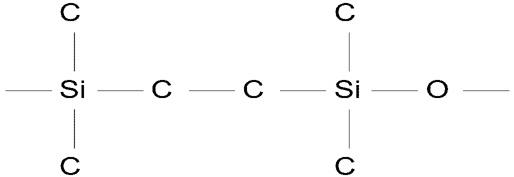
wherein the amount of the carbon atoms of the at least one modified silicone layer is greater than the amount of the carbon atoms of the silicone layer by about 0.01 to 60 mole percent and the amount of the oxygen atoms of the at least one modified silicone layer is less than the amount of the oxygen atoms of the silicone layer by about 0.01 to 60 mole percent.

2. The package structure of claim 1, wherein the at least one modified silicone layer has the interfacial tension and the polarity thereof modified.

3. The package structure of claim 1 or 2, wherein the at least one modified silicone layer includes Epoxy, Acrylic Acid or a combination thereof into silicone.

4. The package structure of claim 1, wherein the amount of the silicone with the chemical formula within the silicone layer is greater than the amount of the silicone with the chemical formula within the at least one modified silicone layer by 0.1 % to 60%, on a weight/volume basis.

5. The package structure of claim 1, wherein the two substrates are formed of materials including polyimide (PI), polyethylene terephthalate (PET), polyethylene naphthalate (PEN), metal, glass, glass fiber, and liquid crystal polymer.

6. The package structure of claim 1, further comprising an auxiliary sealing frame, disposed between the two substrates, and on the outside of the sealing frame.

7. The package structure of claim 6, wherein the auxiliary sealing frame is made of a material selected from the group consisting of epoxy, acrylic resin, UV glue, Polyethylene (PE), ethylene vinyl acetate (EVA), Polypropylene (PP), or a combination thereof.

8. The package structure of claim 6, wherein the auxiliary sealing frame includes three modified silicone layers, wherein the modified silicone layers contain silicone represented by a chemical formula of: 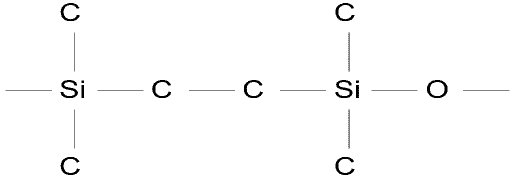 wherein the amount of the carbon atoms of the at least one modified silicone layer is greater than the amount of the carbon atoms of the silicone layer by about 0.01 to 60 mole percent and the amount of the oxygen atoms of the at least one modified silicone layer is less than the amount of the oxygen atoms of the silicone layer by about 0.01 to 60 mole percent.

## Patentansprüche

1. - Package-Struktur, mit:
zwei Substraten; und
einem Dichtrahmen zwischen den beiden zwei Substraten, um einen inneren Umfang abzudichten, um einen Raum darin zu bilden, wobei der Dichtrahmen folgendes umfasst:
eine Silikonschicht; und
mindestens eine modifizierte Silikonschicht, die zwischen mindestens einem der Substrate und der Silikonschicht angeordnet ist, wobei die Silikonschicht Silikon nach der folgenden chemischen Formel enthält: 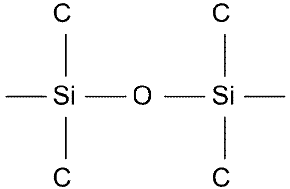
und die modifizierten Silikonschichten Silikon nach der folgenden Formel enthalten: 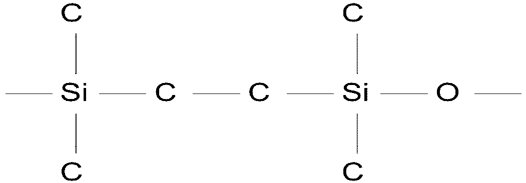
wobei die Menge an Kohlenstoffatomen der mindestens einen modifizierten Silikonschicht um etwa 0,01 bis 60 Molprozent größer ist als die Menge an Kohlenstoffatomen der Silikonschicht und die Menge an Sauerstoffatomen der mindestens einen modifizierten Silikonschicht um etwa 0,01 bis 60 Molprozent geringer ist als die Menge an Sauerstoffatomen der Silikonschicht.

2. - Package-Struktur nach Anspruch 1, wobei die mindestens eine modifizierte Silikonschicht modifizierte Grenzflächenspannung mit modifizierter Polarität hat.

3. - Package-Struktur nach Anspruch 1 oder 2, wobei die mindestens eine modifizierte Silikonschicht Epoxy, Akrylsäure oder eine Kombination davon in Silikon enthält.

4. - Package-Struktur nach Anspruch 1, wobei die Menge an Silikon mit der chemischen Formel innerhalb der Silikonschicht um 0,1% bis 60% größer ist als die Menge an Silikon mit der chemischen Formel innerhalb der mindestens einen modifizierten Silikonschicht, bezogen auf Gewicht/Volumen.

5. - Package-Struktur nach Anspruch 1, wobei die beiden Substrate aus Materialien bestehen, die Polyimid (PI), Polyäthylenterephthalat (PET), Polyäthylennaphthalat (PEN), Metall, Glas, Glasfaser und Flüssigkristallpolymer enthalten.

6. -Package-Struktur nach Anspruch 1, die des weiteren folgendes umfasst: einen Hilfsdichtrahmen zwischen den beiden Substraten und an der Außenseite des Dichtrahmens.

7. - Package-Struktur nach Anspruch 6, wobei der Hilfsdichtrahmen aus einem Material aus folgender Gruppe besteht: Epoxy, Akrylharz, UV-Klebstoff, Polyäthylen (PE), Äthylenvinylazetat (EVA), Polypropylen (PP) oder einer Kombination davon.

8. - Package-Struktur nach Anspruch 6, wobei der Hilfsdichtrahmen drei modifizierte Silikonschichten enthält, wobei die modifizierten Silikonschichten Silikon nach folgender Formel enthalten: 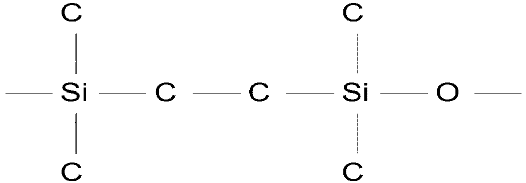 wobei die Menge an Kohlenstoffatomen der mindestens einen modifizierten Silikonschicht um etwa 0.01 bis 60 Molprozent größer ist als die Menge an Kohlenstoffatomen der Silikonschicht und die Menge an Sauerstoffatomen der mindestens einen modifizierten Silikonschicht um etwa 0.01 bis 60 Molprozent geringer ist als die Menge an Sauerstoffatomen der Silikonschicht.

## Revendications

1. - Structure d'emballage comprenant :
deux substrats ; et
un cadre de scellement, disposé entre les deux substrats pour sceller une circonférence interne pour former un espace à l'intérieur de celle-ci, le cadre de scellement comprenant :
une couche de silicone ; et
au moins une couche de silicone modifié disposée entre au moins l'un des substrats et la couche de silicone, la souche de silicone contenant un silicone représenté par une formule chimique de : 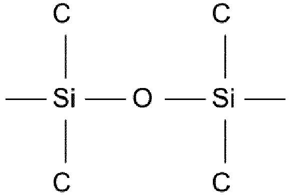
et les couches de silicone modifié contenant un silicone représenté par une formule chimique de : 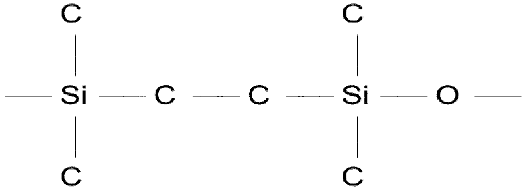
la quantité des atomes de carbone de la au moins une couche de silicone modifié étant supérieure à la quantité des atomes de carbone de la couche de silicone d'environ 0,01 à 60 pour cent en moles, et la quantité des atomes d'oxygène de la au moins une couche de silicone modifié étant inférieure à la quantité des atomes d'oxygène de la couche de silicone d'environ 0,01 à 60 pour cent en moles.

2. - Structure d'emballage selon la revendication 1, dans laquelle la au moins une couche de silicone modifié a la tension interfaciale et la polarité de celle-ci modifiées.

3. - Structure d'emballage selon l'une des revendications 1 ou 2, dans laquelle la au moins une couche de silicone modifié comprend un époxy, de l'acide acrylique ou une combinaison de ceux-ci dans le silicone.

4. - Structure d'emballage selon la revendication 1, dans laquelle la quantité du silicone avec la formule chimique dans la couche de silicone est supérieure à la quantité du silicone avec la formule chimique dans la au moins une couche de silicone modifié de 0,1 % à 60 %, sur une base poids/volume.

5. - Structure d'emballage selon la revendication 1, dans laquelle les deux substrats sont formés de matières comprenant le polyimide (PI), le poly(téréphtalate d'éthylène) (PET), le poly(naphtalate d'éthylène) (PEN), le métal, le verre, la fibre de verre et un polymère cristal liquide.

6. - Structure d'emballage selon la revendication 1, comprenant en outre un cadre de scellement auxiliaire, disposé entre les deux substrats, et sur l'extérieur du cadre de scellement.

7. - Structure d'emballage selon la revendication 6, dans laquelle le cadre de scellement auxiliaire est fait d'une matière choisie dans le groupe consistant en résine époxy, résine acrylique, colle UV, polyéthylène (PE), éthylène-acétate de vinyle (EVA), polypropylène (PP) ou une combinaison de ceux-ci.

8. - Structure d'emballage selon la revendication 6, dans laquelle le cadre de scellement auxiliaire comprend trois couches de silicone modifié, les couches de silicone modifié contenant un silicone représenté par une formule chimique de : 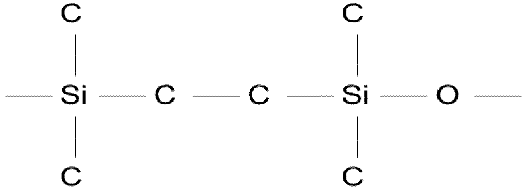 la quantité des atomes de carbone de la au moins une couche de silicone modifié étant supérieure à la quantité des atomes de carbone de la couche de silicone d'environ 0,01 à 60 pour cent en moles, et la quantité des atomes d'oxygène de la au moins une couche de silicone modifié étant inférieure à la quantité des atomes d'oxygène de la couche de silicone d'environ 0,01 à 60 pour cent en moles.
